# EUROPEAN PATENT SPECIFICATION

(11) **EP 1 796 267 B1**
(45) Date of publication and mention of the grant of the patent: **25.02.2009**
(21) Application number: 06025024.8
(22) Date of filing: 04.12.2006
(51) Int. Cl.: H03H 9/10, H01L 21/52, H01L 23/047, H01L 23/10, H01L 23/12

(54) **Electronic component**
Elektronische Komponente
Composant électronique

(30) Priority: 06.12.2005 JP 2005351551
(43) Date of publication of application: 13.06.2007
(73) Proprietor: Epson Toyocom Corporation, Hino-shi, Tokyo 191-8501 (JP)
(72) Inventor: Owaki, Takuya, Hino-shi Tokyo 191-8501 (JP); Adachi, Tadayoshi, Hino-shi Tokyo 191-8501 (JP); Yokokawa, Kazuya, Hino-shi Tokyo 191-8501 (JP); Aoki, Shinya, Hino-shi Tokyo 191-8501 (JP); Yamazaki, Takashi, Hino-shi Tokyo 191-8501 (JP)
(74) Representative: HOFFMANN EITLE

(56) References cited:
- EP-A1- 1 143 504
- DE-A1- 10 139 166
- JP-A- 6 104 687
- JP-A- 7 283 684
- JP-A- 8 293 756
- JP-A- 2001 102 403
- JP-A- 2001 102 888
- US-A- 6 166 437
- US-A1- 2003 132 817

## Description

### BACKGROUND

### 1. Technical Field

The present invention relates to an electronic component, particularly to an electronic component having an element housed in a package.

### 2. Related Art

Electronic components include surface acoustic wave apparatuses in which a surface acoustic wave element is disposed on a bottom surface of a cavity in a package via a metallized layer and in which an electrode of the surface acoustic wave element and an electrode in the package are connected by wire bonding.

Among such surface acoustic wave apparatuses, one has heretofore been known that is configured to have a non-metallized part formed between the surface acoustic wave element and the electrode in the package on the bottom surface of the cavity in the package so as to improve accuracy of the connecting location of at the time of wire bonding (for example, see JP3372065 <figure 1>, JP3154640 <figures 1 to 8>, JP3216638 <figure 1>, and JP3301419 <figure 1>).

In the abovementioned examples, two non-metallized sections, which are opposed with the surface acoustic wave element between them, are each formed between the surface acoustic wave element and the electrodes in the package. As a result, it is possible to form two recognition points distinctly that are opposed with the surface acoustic wave element between them when seen from the top, using the non-metallized sections and the electrodes in the package. Therefore, by interpreting the midpoint of a line segment linking the two recognition points, i.e., the midpoint between the electrodes between which the surface acoustic wave element is interposed, as the midpoint of the package, it is made possible to mount the surface acoustic wave in the package so that the center position of the surface acoustic wave is matched with the center position of the package.

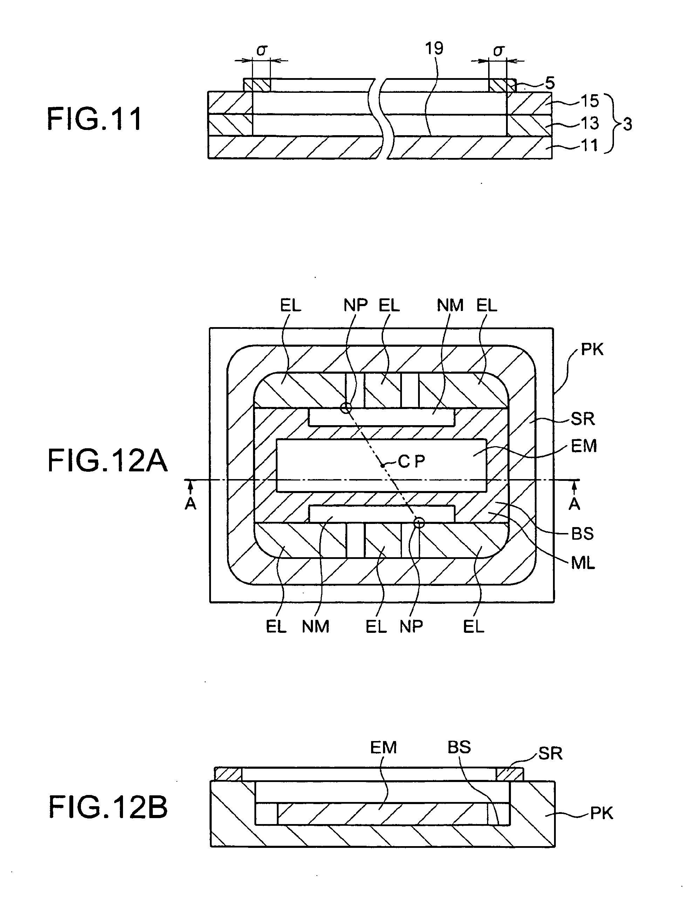

Meanwhile, as shown in Fig. 12A, an electronic component, such as the abovementioned acoustic surface wave apparatus, may be configured so that a package PK, which houses an element EM, and a lid (not shown), which covers an opening of the package PK, are fixed via a seal ring SR. In Fig. 12A, a metallized layer ML on a bottom surface BS of a cavity in the package PK, and an electrode EL and a seal ring SR in the package PK are hatched in order to clarify the configuration. A symbol NM represents a non-metallized section on the bottom surface BS of the cavity in the package PK. For the electronic component thus configured, the center point CP between the abovementioned electrodes in the package may not be the center point of the package PK, on which an element EM is to be mounted, due to a variation in the position of the seal ring SR relative to the package PK. That is, when the seal ring SR is mounted on the package PK, the seal ring SR may make a shift in its position relative to the package PK in a direction intersecting the direction linking the electrodes. Consequently, as shown in Fig. 12B, which is a cross section along A-A line of Fig. 12A, the seal ring SR may cover a part of the bottom surface BS of the cavity in the package PK.

In such a case, when attempting to recognize the center position CP between the electrodes in the package PK based on the two recognition points NP, as shown in Fig. 12A, which are opposed with the element EM between them, to match the center position of the element EM with the center position CP between the electrodes, and then to mount the element EM on the bottom surface BS of the cavity in the package PK, as shown in the abovementioned examples, the element EM or a collet for holding the element EM at the time of mounting the element EM in the package PM may collide with the seal ring SR. To avoid such collision, the size of the package PK relative to the element EM is set to be sufficiently large to accommodate variations in the position of the seal ring SR. Consequently, the abovementioned examples have an unresolved problem that it is difficult to make the size of the package relative to that of the electrode smaller, resulting in a difficulty in miniaturizing the electronic component.

### SUMMARY

An advantage of the invention is to provide an electronic component having miniaturization potential.

An electronic component according to an aspect of the invention includes a package having a cavity formed therein by providing an annular protrusion on a substrate as well as having a metallized layer on a bottom surface of the cavity, and an element disposed on the bottom surface of the cavity via the metallized layer and housed in the cavity, wherein the element has an electrode formed on a surface opposite to a surface which touches the bottom surface of the cavity when the element is disposed on the bottom surface, wherein, in the cavity, an internal electrode to be an electrical connecting destination of the electrode on the element is formed at opposed positions with the element between the positions in a first direction, in which the electrode lies between the positions when seen from the top, in such a manner that there is clearance between the internal electrode and the element, and wherein, on the bottom surface of the cavity, a distinction mark, which is distinguished from the metallized layer, is formed at opposed positions with the element between the positions in a second direction intersecting the first direction when seen from the top and in such a manner that the distinction mark touches the protrusion when seen from the top.

According to this aspect of the invention, the metallized layer and the distinction mark, which is distinguished from the metallized layer, are formed on the bottom surface of the cavity. The distinction mark is formed at opposed positions with the element between the positions in the second direction intersecting the first direction in which the element is interposed between the internal electrodes and in such a manner that the distinction mark touches the protrusion when seen from the top. Consequently, it is made possible to readily recognize the boundary between the distinction mark and the protrusion and thus to recognize the size of cavity in the second direction based on the two boundaries between which the element is interposed in the second direction.

Therefore, even if there is caused a variation in the size of the cavity in the second direction, it is made possible to readily recognize the center position of the size of the cavity in the second direction. Further, mounting the element in the cavity based on this center position allows the collision between the element or collet and the protrusion to be readily avoided. This makes it possible to reduce the size of the package relative to that of the element, and thus to miniaturize the electronic component.

In the package, the protrusion may consist of an annular substrate, and the cavity may be formed by laminating the annular substrate on the substrate on which the metallized layer is formed. Further, the distinction mark may be formed on the substrate so that a part of the distinction mark overlaps the annular substrate.

In this case, the annular substrate is laminated on the substrate so as to cover a part of the distinction mark. Therefore, it is made possible to form a boundary between the distinction mark and the annular substrate with reliability even if there is a variation in the laminating position of the annular substrate relative to the substrate or a variation in the size of the annular substrate.

The distinction mark may be distinguished from the metallized layer by forming a window in the metallized layer and thus exposing the substrate from the window.

Consequently, it is made possible to clearly distinguish the distinction mark from the metallized layer.

The package may be configured so that a middle layer having a surface expanding from an inner side surface of the protrusion toward the element in the first direction is formed in the cavity and so that the internal electrode is formed on the surface of the middle layer. Further, the element may be configured so that the electrode consists of an IDT electrode and so that a surface acoustic wave is generated based on an electrical signal applied to the IDT electrode.

As a result, it is made possible to miniaturize the electronic component that generates a surface acoustic wave.

In this case, the element may be housed in the package so that a direction of propagation of the surface acoustic wave intersects the first direction.

This means that the element is configured so that the direction of propagation of a surface acoustic wave intersects the first direction, that is, a difference between the direction of propagation of the surface acoustic wave and the second direction is made smaller. Therefore, it is made possible to reduce the size of the electronic component in the direction of propagation of a surface acoustic wave.

### BRIEF DESCRIPTION OF THE DRAWINGS

The invention will be described with reference to the accompanying drawings, wherein like numbers reference like elements.

Figs. 1A to 1C are drawings showing a configuration of a surface acoustic wave apparatus according to an embodiment of the invention.

Fig. 2 is a top view showing a surface acoustic wave element of the surface acoustic wave apparatus according to the embodiment of the invention.

Figs. 3A and 3B are drawings showing a configuration of a substrate of the surface acoustic wave apparatus according to the embodiment of the invention.

Figs. 4A and 4B are drawings showing a configuration of a first frame substrate of the surface acoustic wave apparatus according to the embodiment of the invention.

Figs. 5A and 5B are drawings showing a configuration of a second frame substrate of the surface acoustic wave apparatus according to the embodiment of the invention.

Fig. 6 is a top view of a seal ring of the surface acoustic wave apparatus according to the embodiment of the invention.

Fig. 7 is a drawing showing a lid of the surface acoustic wave apparatus according to the embodiment of the invention.

Figs. 8A and 8B are drawings showing a flow of assembly of the surface acoustic wave apparatus according to the embodiment of the invention.

Figs. 9A and 9B are drawings showing a center position of a bottom surface of a cavity in the surface acoustic wave apparatus according to the embodiment of the invention.

Figs. 10A and 10B are drawings showing the center position of the bottom surface of the cavity at a time of a shift in the position of the seal ring of the surface acoustic wave apparatus according to the embodiment of the invention.

Fig. 11 is a drawing showing an advantageous effect of the surface acoustic wave apparatus according to the embodiment of the invention.

Figs. 12A and 12B are drawings showing a problem with the related art.

### DESCRIPTION OF AN EXEMPLARY EMBODIMENT

An embodiment of the invention will now be described using a surface acoustic wave apparatus, which is one of electronic components, as an example referring to the accompanying drawings.

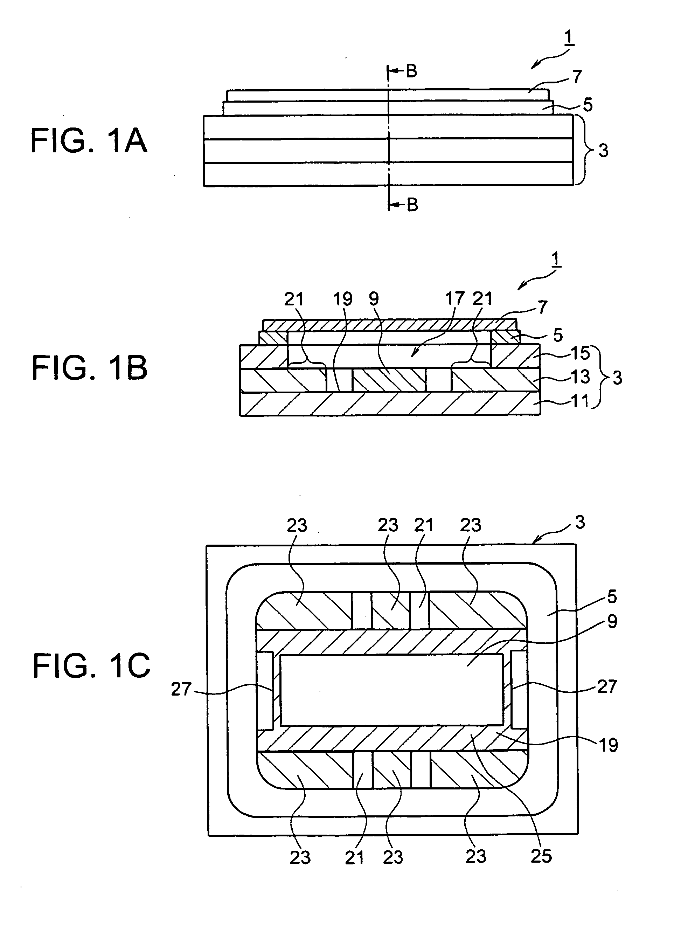

As shown in Fig. 1A, which is a front view, and Fig. 1B, which is a cross section along B-B line of Fig. 1A, a surface acoustic wave apparatus 1 according to the embodiment includes a package 3, a seal ring 5, a lid 7, and a surface acoustic wave element 9 housed in the package 3.

As shown in Fig. 1B, the package 3 includes a substrate 11, a first frame substrate 13 laminated on the substrate 11, and a second frame substrate 15 laminated on the first frame substrate 13. The substrate 11, the first frame substrate 13, and the second frame substrate 15 each consist of a ceramic substrate mainly made of aluminum oxide or silicon oxide.

The package 3 thus configured has a cavity 17 formed therein by laminating the first frame substrate 13 and the second frame substrate 15 on the substrate 11. As shown in Fig. 1B, a surface acoustic wave element 9 is disposed on a bottom surface 19 of the cavity 17 and housed in the package 3.

As shown in Fig. 1B, the inner side surface of the first frame substrate 13 is positioned more inwardly than that of the second frame substrate 15. Consequently, a middle layer 21, which has a surface expanding toward the surface acoustic wave element 9, is formed in the cavity 17 between the substrate 11 and the second frame substrate 15.

In Fig. 1C, which is a top view of the surface acoustic wave apparatus 1 with the lid 7 omitted, the middle layer 21 is formed at opposed positions with the surface acoustic wave element 9 between the positions in a vertical direction when seen in this figure. The middle layer 21 has an internal electrode 23, which is a connecting destination of a variety of electrodes of the surface acoustic wave element 9 to be discussed later, formed thereon.

As shown in Fig. 1C, a metallized layer 25 is formed on the bottom surface 19 of the cavity 17. The surface acoustic wave element 9 is disposed on the bottom surface 19 of the cavity via the metallized layer 25.

On the metallized layer 25, a window 27 is formed between an inner surface of the cavity 17 and the surface acoustic wave element 9 in a direction intersecting the direction in which the two middle layers 21 are opposed with the surface acoustic wave element 9 between them, i.e., in a lateral direction of Fig. 1C so that the substrate 11 is exposed in the window 27. In other words, the interior of the window 27 is distinguished from the metallized layer 25 because the color of the substrate 11 exposed in the window 27 is different from the metallic color of the metallized layer, such as gold or silver.

The window 27 is formed at opposed positions with the surface acoustic wave element 9 between the positions and in such a manner that the window 27 touches an inner surface of the cavity 17. To clarify the configuration, the internal electrode 23 and metallized layer 25 are hatched in Fig. 1C.

The abovementioned configurations will now be described in details.

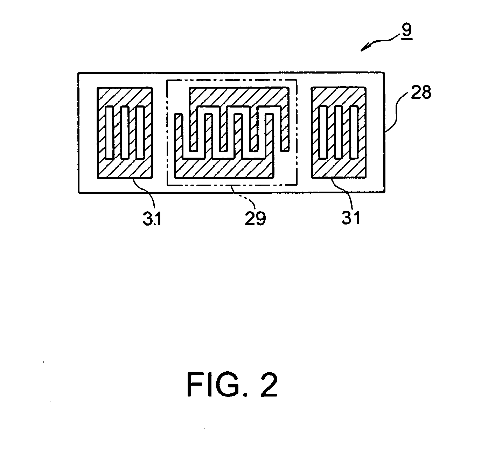

As shown in Fig. 2, which is a top view, the surface acoustic wave element 9 is configured to have an IDT electrode 29 and two reflector electrodes 31 formed on an element substrate 28 formed of a piezoelectric substance such as crystal. To clarify the configuration, the IDT electrode 29 and the reflector electrodes 31 are hatched in Fig. 2.

When an electrical signal is inputted, the IDT electrode 29 excites a surface acoustic wave in the surface acoustic wave element 9. The two reflector electrodes 31 are formed in such a manner that the IDT electrode 29 is interposed between the reflector electrodes 31, and reflects the surface acoustic wave excited by the IDT electrode 29. The direction in which the IDT electrode 29 is interposed between the two reflector electrodes 31 in the surface acoustic wave element 9 is the direction of propagation of the surface acoustic wave.

In other words, the surface acoustic wave element 9 is disposed on the bottom surface 19 of the cavity 17 in such a manner that the surface acoustic wave element 9 is interposed between the two windows 27 formed on the bottom 19 in the direction of propagation of the surface acoustic wave. Portions of the IDT electrode 29 of the surface acoustic wave element 9 are each connected to the internal electrodes 23 in the cavity 17 with a wire (not shown) by wire bonding or the like.

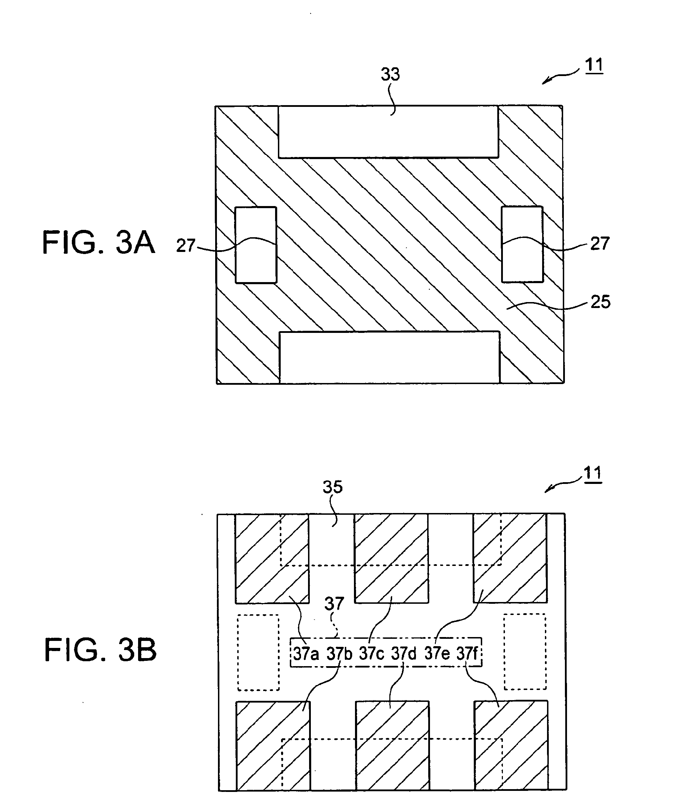

As shown in Fig. 3A, the substrate 11 has the metallized layer 25, which is mainly made of gold or the like, formed on a first surface 33, which is on the side of the bottom surface 19 of the cavity 17. Further, the metallized layer 25 has the two windows 27 formed therein. As shown in Fig. 3B, which is a bottom surface view, a second surface 35 opposite to the first surface 33 of the substrate 11 has an external electrode 37, which is to be connected to a wiring pattern of a circuit substrate or the like (not shown), formed thereon. To clarify the configuration, the metallized layer 25 and the external electrode 37 are hatched in Figs. 3A and 3B.

The external electrode 37 consists of ground electrodes 37A, 37B, 37E, and 37F, which are to be connected to a ground of a circuit substrate or the like, and I/O electrodes 37C and 37D, to which an electrical signal is inputted via the wiring pattern of the circuit substrate or the like and from which a surface acoustic wave signal generated based on the inputted electrical signal is outputted. The metallized layer 25 is electrically connected to the ground electrodes 37A, 37B, 37E, and 37F through a via hole or castellation (not shown).

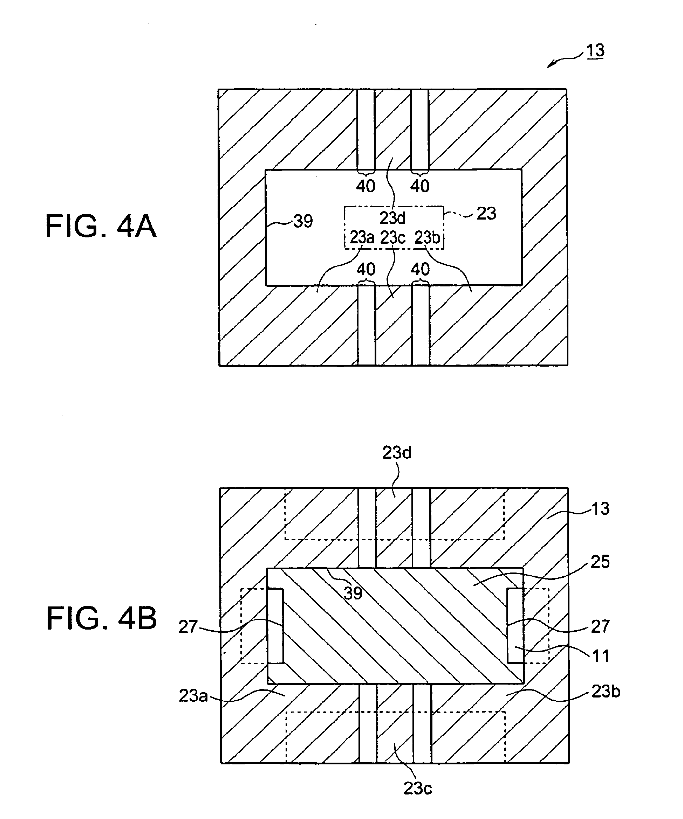

As shown in Fig. 4A, the first frame substrate 13 consists of an annular substrate having an opening 39 formed therethrough in a thickness direction. The internal electrode 23, which is formed on the first frame substrate 13, is mainly made of gold or the like. The internal electrode 23 consists of IDT-targeted internal electrodes 23C and 23D, to which the portions of the IDT 29 are to be connected, and ground internal electrodes 23A and 23B, which are to be electrically connected to the ground electrodes 37A, 37B, 37E, and 37F of the substrate 11 through a via hole, castellation, or the like (now shown). The IDT-targeted internal electrodes 23C and 23D are provided at opposed positions with the opening 39 between the positions in a vertical direction of Fig. 4A, and each interposed between the ground internal electrodes 23A and 23B via an inter-electrode section 40 in a lateral direction.

The IDT-targeted internal electrodes 23C and 23D are electrically connected to the I/O electrodes 37C and 37D of the substrate 11, respectively, through a via hole, castellation, or the like (not shown). To clarify the configuration, the ground internal electrodes 23A and 23B and the IDT-targeted internal electrodes 23C and 23D are hatched in Fig. 4A. While the embodiment is configured so that the reflector electrodes 31 of the surface acoustic wave element 9 are not connected to the internal electrode 23, the reflector electrodes 31 may be connected to the IDT-targeted internal electrodes 23C and 23D or the ground internal electrodes 23A and 23B.

As shown in Fig.4B, which is a top view with the first frame substrate 13 laminated on the substrate 11, the size of the opening 39 of the first frame substrate 13 is set such that a part of the window 27 of the substrate 11 is exposed from inside of the opening 39.

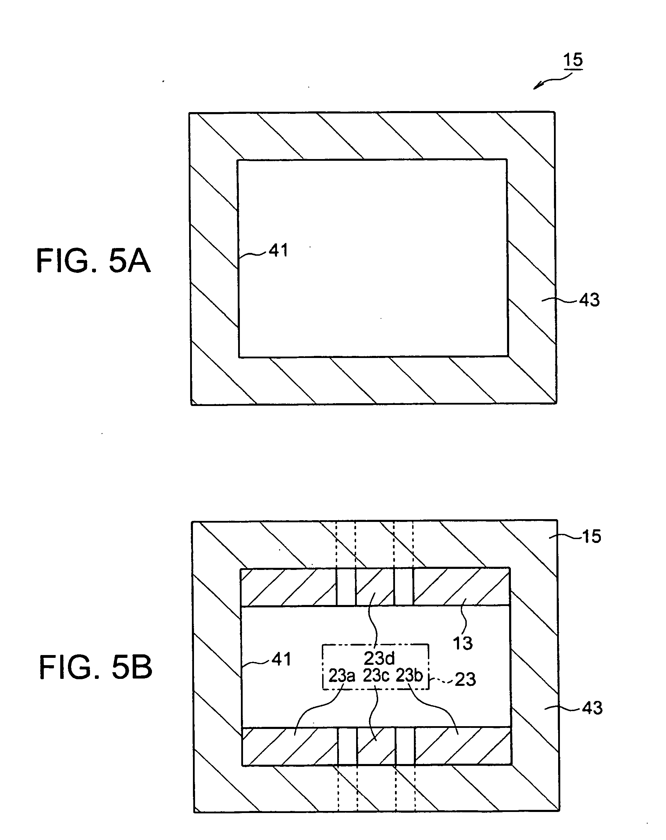

As shown in Fig. 5A, which is a top view, the second frame substrate 15 consists of an annular substrate having an opening 41 formed therethrough in a thickness direction. As shown in Fig. 5B, which is a top view with the second frame substrate 15 laminated on the first frame substrate 13, the size of the opening 41 of the second frame substrate 15 is set such that a part of each of the ground internal electrodes 23A and 23B and the IDT-targeted internal electrodes 23C and 23D formed on the first frame substrate 13 is exposed from inside of the opening 41.

The second frame substrate 15 has the metallized layer 43 formed thereon, which is hatched in Figs. 5A and 5B. The metallized layer 43 is mainly made of gold or the like.

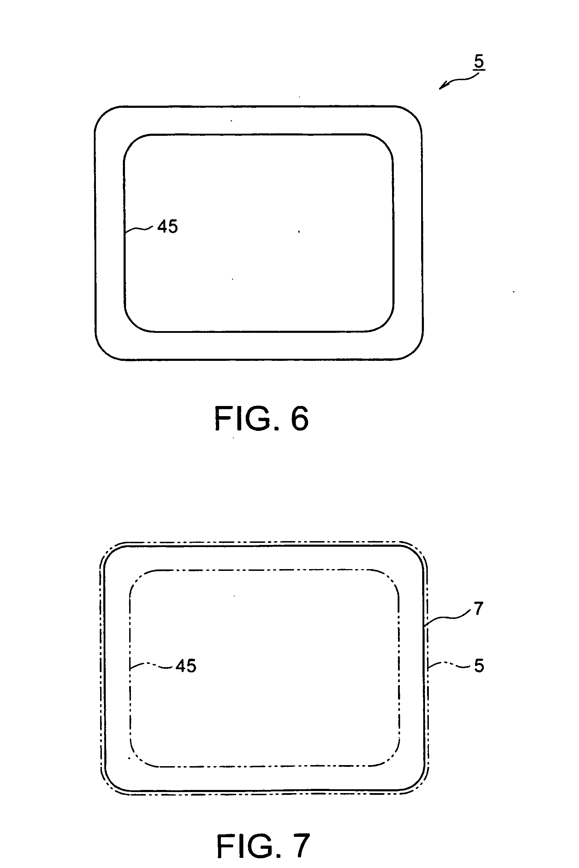

As shown in Fig. 6, which is a top view, the seal ring 5, which is formed of an alloy mainly made of iron and nickel, is formed in an annular shape with an opening 45 provided therethrough in a thickness direction. As shown in Fig. 7, which is a top view, the size of the lid 7, which is formed of a metal, is set such that, with the lid 7 laminated on the seal ring 5, the lid 7 may cover the inner circumference of the opening 45 of the seal ring 5 and the outline of the lid 7 may fall within the outer circumference of the seal ring 5.

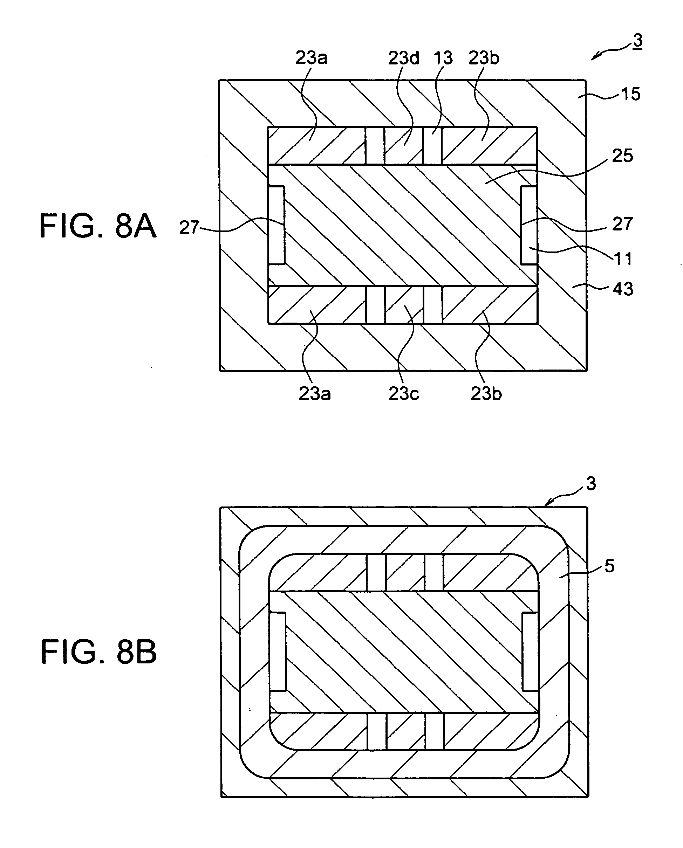

Description will now be made on a flow of assembly of the surface acoustic wave apparatus 1 thus configured. When assembling the surface acoustic wave apparatus 1, at first, the first frame substrate 13 and the second frame substrate 15 are laminated on the substrate 11, and then calcining is conducted to form the package 3 as shown in Fig. 8A. When forming the package 3, a plating base layer is formed on the respective relevant portions of the substrate 11, the first frame substrate 13, and the second frame substrate 15, then calcining is conducted, and then gold plating is conducted to form the electrodes 23 and 37 and the metallized layers 25 and 43.

Specifically, a plating base layer, which is mainly made of a high melting point metal, such as tungsten, is formed on portions of the substrate 11 on which the metallized layer 25 and the external electrode 37 are to be formed, on a portion of the first frame substrate 13 on which the internal electrode 23 is to be formed, and on a portion of the second frame substrate 15 on which the metallized layer 43 is to be formed. By laminating the substrate 11, the first frame substrate 13, and the second frame substrate 15, which each have the plating base layer formed on the relevant portions thereof, then conducting calcining, and then conducting gold plating, the package 3 is formed as shown in Fig. 8A.

As shown in Fig. 8B, the seal ring 5 is disposed on the package 3. At this time, the seal ring 5 is brazed to the second frame substrate 15 of the package 3 by silver brazing or the like. Portions of the package 3, which show a metal color such as gold or silver, are hatched in Figs. 8A and 8B.

Subsequently, the surface acoustic wave element 9 is placed in the cavity 17 of the package 3, to which the seal ring 5 is brazed. At this time, the center position of the bottom surface 19 of the cavity 17 is recognized using an image recognition system including an image pickup device such as CCD (Charge Coupled Device). Then, the surface acoustic wave element 9 is placed in an appropriate position based on the recognized center position of the bottom surface 19.

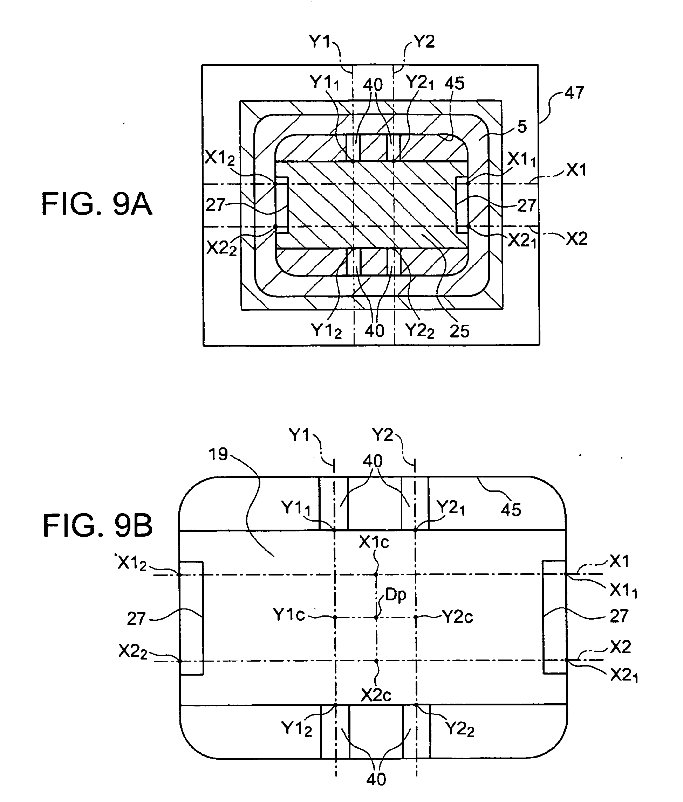

Description will now be made on recognition of the center position of the bottom surface 19 using the image recognition system. As shown in Fig. 9A, which is a view showing an image caught via the image pickup device, the image recognition system used in the embodiment provides two lateral sight lines X1 and X2 and two vertical sight lines Y1 and Y2 in an image input region 47. Portions, which show a metal color such as gold and silver, are hatched in Fig. 9A.

The sight lines X1 and X2 are provided such that those lines have an interval, are in parallel, and go across the windows 27 in a lateral direction of Fig. 9A. The sight lines Y1 and Y2 are provided such that those lines have an interval, are in parallel, and go across the electrodes 40 in a vertical direction of Fig. 9A. The image recognition system is configured so that a boundary between a metallic color such as gold or silver and the color of a ceramic substrate or the like is recognized as a recognition point on the sight lines X1 and X2 and the sight lines Y1 and Y2.

Specifically, boundaries between the seal ring 5 and the windows 27 are recognized as recognition points X1₁ and X1₂ and X2₁ and X2₂ on the sight lines X1 and X2. Boundaries between the inter-electrode sections 40 and the metallized layer 25 are recognized as recognition points Y1₁ and Y1₂ and Y2₁ and Y2₂ on the sight lines Y1 and Y2.

As shown in Fig. 9B, which is an enlarged view of the interior of the opening 45 of the seal ring 5 shown in Fig. 9A, when the recognition points X1₁, X1₂, X2₁, X2₂, Y1₁, Y1₂, Y2₁, and Y2₂ are recognized, a center position Dp of the bottom surface 19 is calculated by a computing unit (not shown). Specifically, a midpoint X1c between the recognition points X1₁, and X1₂, a midpoint X2c between the recognition points X2₁ and X2₂, a midpoint Y1c between the recognition points Y1₁ and Y1₂, and a midpoint Y2c between the recognition points Y2₁ and Y2₂ are initially calculated. Then, the intersecting point of a line segment linking the midpoints X1c and X2c and a line segment linking the midpoints Y1c and Y2c is calculated as Dp.

Based on the center position Dp of the bottom surface 19 thus recognized, the position on which the surface acoustic wave element 9 is to be mounted is determined. After mounting the surface acoustic wave element 9 on the bottom surface 19 of the cavity 17, the portions of the IDT electrode 29 of the surface acoustic wave element 9 are electrically connected to the internal electrode 23.

Subsequently, the lid 7 is mounted on the seal ring 5, and then the lid 7 and the seal ring 5 are seam welded. This completes assembly of the surface acoustic wave apparatus 1 shown in Fig. 1A. The lid 7 is electrically connected to the ground electrodes 37A, 37B, 37E, and 37F of the substrate 11 through a via hole, castellation, or the like (not shown). In other words, the surface acoustic wave element 9 is shielded against noise from outside, such as electromagnetic wave, by the lid 7 and the metallized layer 25 each grounded, and thus its operation is stabilized.

In the embodiment, the first frame substrate 13 and the second frame substrate 15 each correspond to the annular substrate as a protrusion, and the window 27 corresponds to the distinction mark.

The surface acoustic wave apparatus 1 according to the embodiment has the metallized layer 25 as well as the window 27, which is distinguished from the metallized layer 25, formed on the bottom surface 19 of the cavity 19. The window 27 is formed at opposed positions with the surface acoustic wave element 9 between the positions in a direction intersecting a direction in which the surface acoustic wave element 9 is interposed between the internal electrodes 23 and so that a part of the window 27 overlaps the first frame substrate 13 when seen from the top. Consequently, the window 27 is clearly distinguished from the first frame substrate 13, the second frame substrate 15, and the seal ring 5. Further, it is made possible to readily recognize a boundary between the first frame substrate 13, the second frame substrate 15, or the seal ring 5 and the window 27 using an image recognition system. This allows the center position of the bottom surface 19 when seen from the top to be readily recognized.

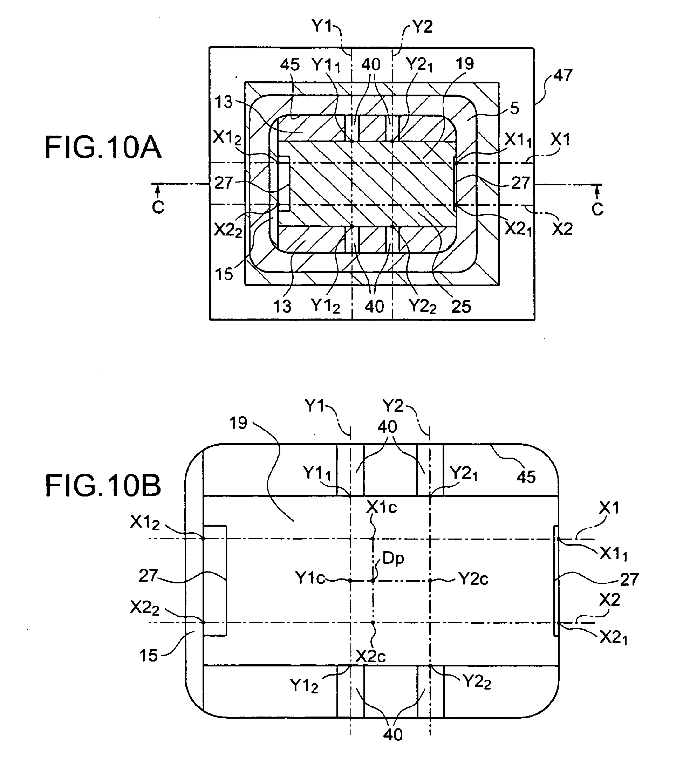

A case will now be considered in which, as shown in Fig. 10A, the disposing position of the seal ring 5 relative to the package 3 is shifted in a left direction of the figure. In this case, the size of the bottom surface 19 of the cavity 17 in Fig. 10A becomes that of the area surrounded by the seal ring 5, the first frame substrate 13, and the second frame substrate 15, which is smaller than shown in Fig. 9A.

However, the surface acoustic wave apparatus 1 according to the embodiment allows the center position Dp of the bottom surface 19 to be readily recognized. In other words, it is made possible to calculate the center position Dp depending on the size of the bottom surface 19 even when the size of the bottom surface 19 when seen from the top varies.

The disposing position of the seal ring 5 relative to the package 5 may be shifted not only in the left direction shown in Fig. 10A but also in a right direction. Specifically, the disposing position of the seal ring 5 relative to the package 3 varies by σ in the left direction as well as varies by σ in the right direction as shown in Fig. 11, which is a cross section along C-C line of Fig. 10A.

When the window 27 is not formed in the surface acoustic wave apparatus 1, that is, when the center position of the bottom surface 19 is recognized using only the sight lines Y1 and Y2 in the image recognition system used in the embodiment, the disposing position of the seal ring 5 that varies by o in both the left and right directions is not recognized. Therefore, it is necessary to reduce the size of the surface acoustic wave element 9 housed in the package 3 at least by double the variation σ.

On the other hand, the surface acoustic wave apparatus 1 according to the embodiment makes it possible to recognize the center position Dp depending on the size of the bottom surface 19 when seen from the top. Therefore, it is possible to reduce the size of the surface acoustic wave element 9 by the variation σ, thus allowing reduction of the size of the package 3 relative to that of the surface acoustic wave element 9. In other words, it is made possible to make the size of the surface acoustic wave element 9 relative to the package 3 larger. This is extremely preferable to the surface acoustic wave apparatus 1 because the surface acoustic wave element 9 demonstrates a better property as the size of the surface acoustic wave element 9 is increased in the direction of propagation of a surface acoustic wave.

In the embodiment, the window 27 is formed to provide a distinction mark that is distinguished from the metallized layer 25 by color. The invention is not limited to the embodiment. It is possible to form a distinction mark on the metallized layer 25 with coating, ink, or the like that has a color different from that of the metallized layer 25. The distinction mark is not limited to coating or ink. Further, an arbitrary material can be used if the color of the material is different from that of the metallized layer 25. In this case, it is made possible to form the metallized layer 25 entirely on the bottom surface 19 of the cavity 17.

This allows the surface acoustic wave element 9 to be more strongly shielded against noise such as electromagnetic wave, further stabilizing operation of the element.

## Claims

1. An electronic component comprising:
a package (3) having a cavity (17) formed therein by providing an annular protrusion on a substrate (11) as well as having a metallized layer (25) on a bottom surface (19) of the cavity; and
an element (9) disposed on the bottom surface (19) of the cavity (17) via the metallized layer and housed in the cavity,
wherein the element has an electrode formed on a surface opposite to a surface which touches the bottom surface of the cavity when the element is disposed on the bottom surface, wherein, in the cavity, an internal electrode (23) to be an electrical connecting destination of the electrode on the element is formed at opposed positions with the element between the positions in a first direction, in which the electrode lies between the positions when seen from the top, in such a manner that there is clearance between the internal electrode and the element, and wherein, on the bottom surface of the cavity, a distinction mark, which is distinguished from the metallized layer, is formed in the metallized layer at opposed positions with the element between the positions in a second direction intersecting the first direction when seen from the top and in such a manner that the distinction mark touches the protrusion when seen from the top.

2. The electronic component according to claim 1, wherein, in the package, the protrusion consists of an annular substrate, and the cavity is formed by laminating the annular substrate on the substrate on which the metallized layer is formed, and wherein the distinction mark is formed on the substrate so that a part of the distinction mark overlaps the annular substrate.

3. The electronic component according to claim 1, wherein the distinction mark is distinguished from the metallized layer by forming a window in the metallized layer and thus exposing the substrate from the window.

4. The electronic component according to claim 1, wherein the package is configured so that a middle layer having a surface expanding from an inner side surface of the protrusion toward the element in the first direction is formed in the cavity and so that the internal electrode is formed on the surface of the middle layer, and wherein the element is configured so that the electrode consists of an IDT electrode and so that a surface acoustic wave is generated based on an electrical signal applied to the IDT electrode.

5. The electronic component according to claim 4, wherein the element is housed in the package so that a direction of propagation of the surface acoustic wave intersects the first direction.

## Patentansprüche

1. Elektronische Komponente, umfassend:
ein Paket (3) mit einer Höhlung (17), die darin, durch Bereitstellen einer ringförmigen Vorwölbung auf einem Substrat (11), ausgeformt ist, wie auch mit einer metallisierten Schicht (25) auf einer Bodenoberfläche (19) der Höhlung; und
ein auf der Bodenoberfläche (19) der Höhlung (17) angeordnetes Element (9) mittels der metallisierten Schicht und in der Höhlung aufgenommen;
wobei das Element eine auf einer Oberfläche gegenüberliegend einer Oberfläche, die die Bodenoberfläche der Höhlung berührt, ausgebildete Elektrode aufweist, wenn das Element auf der Bodenoberfläche angeordnet ist, wobei in der Höhlung eine interne Elektrode (23), die eine elektrische Verbindungszielorientierung der Elektrode auf dem Element sein soll, an gegenüberliegenden Positionen ausgebildet ist, wobei das Element zwischen den Positionen in einer ersten Richtung liegt, wobei die Elektrode bei Sicht von oben zwischen den Positionen liegt, in solch einer Weise, dass es einen freien Raum zwischen der internen Elektrode und dem Element gibt, und wobei auf der Bodenoberfläche der Höhlung eine Unterscheidungsmarkierung, die sich von der metallisierten Schicht unterscheidet, in der metallisierten Schicht an gegenüberliegenden Positionen ausgebildet ist, mit dem Element zwischen den Positionen in einer zweiten Richtung, welche die erste Richtung bei Sicht von oben und in solcher Weise schneidet, dass die Unterscheidungsmarke die Vorwölbung bei Sicht von oben berührt.

2. Elektronische Komponente gemäß Anspruch 1, wobei im Paket die Vorwölbung aus einem ringförmigen Substrat besteht und die Höhlung durch Laminieren des ringförmigen Substrats auf dem Substrat, auf dem die metallisierte Schicht ausgebildet ist, ausgebildet ist und wobei die Unterscheidungsmarkierung auf dem Substrat so ausgebildet ist, dass ein Teil der Unterscheidungsmarkierung mit dem ringförmigen Substrat überlappt.

3. Elektronische Komponente gemäß Anspruch 1, wobei die Unterscheidungsmarkierung von der metallisierten Schicht durch Ausbilden eines Fensters in der metallisierten Schicht und somit Exponieren des Substrats aus dem Fenster unterschieden ist.

4. Elektronische Komponente gemäß Anspruch 1, wobei das Paket so konfiguriert ist, dass eine Mittelschicht mit einer sich von einer inneren Seitenoberfläche der Vorwölbung hin zum Element in der ersten Richtung erstreckenden Oberfläche in der Höhlung und so ausgebildet ist, dass die interne Elektrode auf der Oberfläche der Mittelschicht ausgebildet ist, und wobei das Element so konfiguriert ist, dass die Elektrode aus einer IDT-Elektrode besteht und so, dass eine Oberflächenschallwelle basierend auf einem elektrischen Signal erzeugt wird, das an die IDT-Elektrode angelegt ist.

5. Elektronische Komponente gemäß Anspruch 4, wobei das Element in dem Paket so aufgenommen ist, dass eine Ausbreitungsrichtung der Oberflächenschallwelle die erste Richtung schneidet.

## Revendications

1. Composant électronique comprenant :
un boîtier (3) ayant une cavité (17) formée dans celui-ci par la présence d'une protubérance annulaire prévue sur un substrat (11) et ayant aussi une couche métallisée (25) sur une surface de fond (19) de la cavité ; et
un élément (9) disposé sur la surface de fond (19) de la cavité (17) via la couche métallisée et logé dans la cavité,
dans lequel l'élément dispose d'une électrode formée sur une surface opposée à une surface qui est en contact avec la surface de fond de la cavité lorsque l'élément est disposé sur la surface de fond, dans lequel, dans la cavité, est formée une électrode interne (23) prévue pour être une destination de connexion électrique de l'électrode présente sur l'élément à des positions opposées avec l'élément entre les positions dans une première direction, dans lequel l'électrode se trouve entre les positions dans une vue depuis le haut, d'une manière telle qu'il y ait un espace entre l'électrode interne et l'élément, et dans lequel, sur la surface de fond de la cavité, une marque distinctive, qui est distincte de la couche métallisée, est formée dans la couche métallisée à des positions opposées avec l'élément entre les positions dans une seconde direction recoupant la première direction dans une vue depuis le haut et d'une manière telle que la marque distinctive soit en contact avec la protubérance dans une vue depuis le haut.

2. Composant électronique selon la revendication 1, dans lequel, dans le boîtier, la protubérance est constituée d'un substrat annulaire, et la cavité est formée en laminant le substrat annulaire sur le substrat sur lequel est formée la couche métallisée, et dans lequel la marque distinctive est formée sur le substrat de telle sorte qu'une partie de la marque distinctive déborde du substrat annulaire.

3. Composant électronique selon la revendication 1, dans lequel la marque distinctive est distincte de la couche métallisée en formant une fenêtre dans la couche métallisée et en exposant ainsi le substrat à partir de la fenêtre.

4. Composant électronique selon la revendication 1, dans lequel le boîtier est configuré de telle sorte qu'une couche médiane ayant une surface s'étendant depuis une surface de côté interne de la protubérance en direction de l'élément dans la première direction soit formée dans la cavité et de telle sorte que l'électrode interne soit formée sur la surface de la couche médiane, et dans lequel l'élément est configuré de telle sorte que l'électrode soit constituée d'une électrode de transducteur acoustique IDT et qu'une onde acoustique de surface soit générée sur base d'un signal électrique appliqué à l'électrode du transducteur IDT.

5. Composant électronique selon la revendication 4, dans lequel l'élément est logé dans le boîtier de telle sorte qu'une direction de propagation de l'onde acoustique de surface recoupe la première direction.
